**Europäisches Patentamt**

**European Patent Office**

**Office européen des brevets**

(19)

(11) Veröffentlichungsnummer: **0 202 455**
**B1**

(12)

# EUROPÄISCHE PATENTSCHRIFT

(45) Veröffentlichungstag der Patentschrift: **16.01.91**

(21) Anmeldenummer: **86104925.2**

(22) Anmeldetag: **10.04.86**

(51) Int. Cl.⁵: **G 01 R 33/30**, G 01 N 24/08

(54) Verfahren und Vorrichtung zur Aufnahme von Kernresonanzsignalen.

(30) Priorität: **17.05.85 DE 3517812**

(43) Veröffentlichungstag der Anmeldung:
**26.11.86 Patentblatt 86/48**

(45) Bekanntmachung des Hinweises auf die
Patenterteilung:
**16.01.91 Patentblatt 91/03**

(84) Benannte Vertragsstaaten:
**DE FR GB NL**

(56) Entgegenhaltungen:
**EP-A-0 145 915**

**JOURNAL OF MAGNETIC RESONANCE, Band
59, September 1984, Seiten 406-429, Academic
Press Inc., New York, US; M.R. BENDALL:
"Elimination of high-flux signals near surface
coils and field gradient sample localization
using depth pulses"**

(73) Patentinhaber: **Bruker Medizintechnik GmbH
Silberstreifen
D-7512 Rheinstetten-Forchheim (DE)**

(72) Erfinder: **Zeiger, Heinz, Dr.
Hellenstrasse 31
D-7517 Waldbronn (DE)**
Erfinder: **Laukien, Günther R. Prof. Dr. Dipl.-
Phys.
Silberstreifen
D-7512 Rheinstetten 4 (DE)**

(74) Vertreter: **Patentanwälte Kohler - Schwindling -
Späth
Hohentwielstrasse 41
D-7000 Stuttgart 1 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

(56) Entgegenhaltungen:

PHYSICS ABSTRACTS, Science Abstracts, Serie A, Band 88, Nr. 1248, Januar 1985, Seiten 739-740, Zusammenfassung Nr. 9030, London, GB; P.A. BOTTOMLEY et al.: "Depth-resolved surface-coil spectroscopy (DRESS) for in vivo 1H, 31P, and 13C NMR", & J. MAGN. RESONANCE (USA) vol. 59, no. 2, p. 338-42 (Sept. 1984)

JOURNAL OF MAGNETIC RESONANCE, Band 55, 1983, Seiten 164-169, Academic Press Inc., New York, US; A. HAASE et al.: "Spatial localization of high resolution 31P spectra with a surface coil"

JOURNAL OF MAGNETIC RESONANCE, Band 62, 1985, Seiten 397-405, Academic Press, Inc., New York, US; P. STYLES et al.: "A concentric surface-coil probe for the production of homogeneous B1 fields"

**Beschreibung**

Die Erfindung betrifft ein Verfahren und eine Vorrichtung zur Aufnahme von Kernresonanzsignalen in definierten Bereichen eines Meßkörpers, der sich in einem homogenen Konstant-Magnetfeld befindet, wobei ein Meßkopf verwendet wird, der eine auf den Meßkörper aufsetzbare Hochfrequenz-Sende- und/oder -Empfangseinrichtung umfaßt, die als Wendelleitung mit koaxialer Abschirmung ausgebildet ist, die an mindestens einem Ende offen und am anderen Ende anschlußfrei ist, wobei die oberste, mit der Abschirmung über einen Anschluß verbundene Windung der Wendelleitung sich etwa in der Ebene des oberen offenen Endes befindet und dort die Aufsetzebene bildet, wobei durch Variation des Hochfrequenz-Speisestromes einer zum Meßkopf koaxialen Sendespule mindestens eine Fläche konstanter magnetischer Hochfrequenz-Feldstärke in einem definierten Abstand oberhalb der Aufsetzebene erzeugt wird, in der bei impulsförmig getastetem Speisestrom für eine vorgegebene Kernart die Resonanzbedingung unter Bezug auf das homogene Konstant-Magnetfeld erfüllt ist.

Ein Verfahren und eine Vorrichtung dieser Art sind aus dem europäischen Patent EP-A-0 145 915 bekannt, das erst nach dem Prioritätsdatum der vorliegenden Patentanmeldung veröffentlicht wurde und dessen Offenbarungsinhalt durch diese Bezugnahme auch zum Offenbarungsinhalt der vorliegenden Anmeldung gemacht wird.

Der vorliegenden Anmeldung liegt die Aufgabe zugrunde, ein Verfahren und eine Vorrichtung gemäß EP-A-0 145 915 noch in der Weise weiterzubilden, daß der Informationsgehalt der erhaltenen Meßergebnisse erhöht und damit Messungen erleichtert und zeitlich verkürzt werden können.

Diese Aufgabe wird nach dem erfindungsgemäßen Verfahren dadurch gelöst, daß eine Bilddarstellung der einen ausgewählten Fläche in ihrer Ebene vorgenommen wird.

Die Aufgabe wird nach der erfindungsgemäßen Vorrichtung dadurch gelöst, daß zuzüglich zur Sende/Empfangseinrichtung eine Darstellungseinrichtung vorgesehen ist, die die in dem durch mindestens eine Fläche definierten räumlichen Bereich des Meßkörpers angeregte Kernresonanz bildlich darstellt.

Die Erfindung hat damit den Vorteil, daß zusätzlich zu den in der EP-A-0 145 915 genannten Vorteilen definierte Ebenen im Meßkörper nicht nur "angefahren", sondern auch sofort bildlich dargestellt werden können, wodurch eine sofortige Beurteilung des Meßergebnisses möglich ist. Für eventuell nachfolgende Messungen oder Bearbeitungen kann auf diese Weise sofort eine Entscheidung getroffen werden.

Wird das erfindungsgemäße Verfahren bzw. die Vorrichtung beispielsweise an menschlichen oder tierischen Körpern verwendet, kann durch Variation des Abstandes der ausgewählten Fläche von der Aufsetzebene ein beträchtliches Körpervolumen "durchfahren" werden, wobei die Bilddarstellung sofort zeigt, ob beispielsweise in dem durchfahrenen Volumen ein auffälliger Bereich liegt, etwa ein Tumor.

Diese schnelle Untersuchungsmethode erfordert im Gegensatz zu üblichen Ganzkörper-Tomographen keine großräumigen Sende- und Empfangsspulen, sondern kann durch Aufsetzen eines verhältnismäßig kleinen Meßkopfes auf den Körper ohne die Gefahr von Störstrahlungen nach außen oder Störeinstrahlungen in den Meßkopf selbst durchgeführt werden.

Bei einer bevorzugten Ausgestaltung der Erfindung ist in mindestens zwei der Flächen die 90°- bzw. 270°- bzw. 450°...-Bedingung der gepulsten magnetischen Kernresonanz erfüllt.

Diese Maßnahme hat den Vorteil, daß gleichzeitig mehrere, definiert voneinander beabstandete Flächen bzw. ebene Bereiche des Meßkörpers angeregt werden, so daß bei entsprechender Ausstattung der Darstellungseinrichtung gleichzeitig mehrere Ebenen übereinander als Bild betrachtet werden können. Hierdurch wird die effektive Meßzeit noch weiter vermindert, weil mit einer einzigen Messung bereits eine mehr oder weniger grob gerasterte Übersicht über den gesamten interessierenden Raumbereich des Meßkörpers möglich ist.

In weiterer bevorzugter Ausgestaltung der Erfindung kann durch Überlagerung und definierte Einstellung eines in der Spulenachse wirkenden Gradienten des Konstant-Magnetfeldes eine der mehreren Flächen ausgewählt werden.

Diese Maßnahme hat den Vorteil, daß durch Auswahl einer einzigen interessierenden Fläche der Aufwand an Rechenzeit für die Bilddarstellung vermindert werden kann. Man kann sich also zunächst nach der zuvor beschriebenen Variante durch gleichzeitige Anregung mehrerer übereinander liegender Ebenen einen Überblick verschaffen, was allerdings einen gewissen Aufwand an Rechenzeit für die Bilddarstellung der mehreren Ebenen erfordert, und sich dann auf eine dieser Ebenen durch geeignete Einstellung des Gradienten konzentrieren, weil bei Anlegen des Gradienten die Resonanzbedingung nur noch für die eine ausgewählte Ebene erfüllt ist. Die Darstellungseinrichtung braucht dann auch nur noch die Bilddarstellung dieser einen Ebene vorzunehmen.

Die Bilddarstellung kann gemäß weiterer Varianten der Erfindung entweder die Spindichte oder die chemische Verschiebung jedes Bildpunktes anzeigen, wie dies an sich bekannt ist.

Bei einer weiteren besonders bevorzugten Ausgestaltung der Erfindung erfolgt nach Vornahme der Bilddarstellung in dem durch die Fläche ausgewählten definierten Bereich des Meßkörpers oder in einem Teil dieses Bereiches eine hochauflösende Kernresonanzmessung.

Diese Maßnahme ist dann von besonderem Vorteil, wenn man sich durch eine Bilddarstellung einer Ebene zunächst einen Überblick über einen flächenhaften Bereich des Meßkörpers verschafft und dort festgestellt hat, daß es einen auffälligen Bereich gibt, der einer näheren Untersuchung bedarf. Man kann nun durch an sich bekannte Maßnahmen in dem gesamten flächenhaften Bereich oder dem interessierenden Teil davon eine hochauflösende Kernresonanzmessung durchführen und aus dem aufgenommenen Spektrum auf die chemische Zusammensetzung in dem ausgemessenen Bereich des Meßkörpers schließen.

Wie ohne weiteres ersichtlich ist, ist auf diese Weise insgesamt eine überaus schnelle Diagnose möglich, weil in einem ersten Schritt durch gleichzeitige Bilddarstellung mehrerer voneinander beabstandeter Ebenen ein grob gerasterter Überblick über das gesamte Volumen des Meßkörpers erfolgen kann, dann eine dieser Ebenen ausgewählt und — ggf. bei erhöhter Auflösung der Bilddarstellung — betrachtet wird und schließlich ein ausgewählter punktueller Bereich einer hochauflösenden Kernresonanzmessung unterzogen wird. Mit nur drei Schritten kann man auf diese Weise einen Meßpunkt exakt lokalisieren und chemisch analysieren.

Bei weiteren Varianten der Erfindung kann man als Sendespule entweder die Wendelleitung des Meßkopfes selbst oder aber eine getrennte Sendespule verwenden, die zum Meßkopf koaxial ist und eine Helmholtz-Spule oder eine Wendelleitung eines weiteren Meßkopfes sein kann.

Es versteht sich, daß ferner in ebenfalls an sich bekannter Weise die Messungen unter gleichzeitiger Entkopplung der gleichen oder einer anderen Kernart erfolgen kann.

Weitere Vorteile ergeben sich aus der Beschreibung und der beigefügten Zeichnung.

Ausführungsbeispiele der Erfindung sind in der Zeichnung dargestellt und werden in der nachfolgenden Beschreibung näher erläutert. Es zeigen:

Fig. 1 eine schematische räumliche Darstellung einer Spektrometeranordnung, mit der das erfindungsgemäße Verfahren durchgeführt bzw. die erfindungsgemäße Vorrichtung verwendet werden kann;

Fig. 2 eine Prinzipdarstellung eines erfindungsgemäßen Meßkopfes im Querschnitt zur Erläuterung der sich einstellenden Feldverteilung;

Fig. 3 eine Darstellung — in vergrößertem Maßstab — eines Ausschnitts aus Fig. 2;

Fig. 4 eine Prinzipdarstellung einer Variante einer Spektrometeranordnung mit variabel einstellbarem Feldgradienten;

Fig. 5 bis 7 Bilddarstellungen von Meßergebnissen, wie sie mit dem erfindungsgemäßen Verfahren bzw. der erfindungsgemäßen Vorrichtung erzielt werden können unter Variation des eingespeisten Hochfrequenzstromes;

Fig. 8 eine Bilddarstellung in einer Ebene senkrecht zu den Darstellungen gemäß Fig. 5 bis 7, jedoch für ein davon abweichendes Meßobjekt.

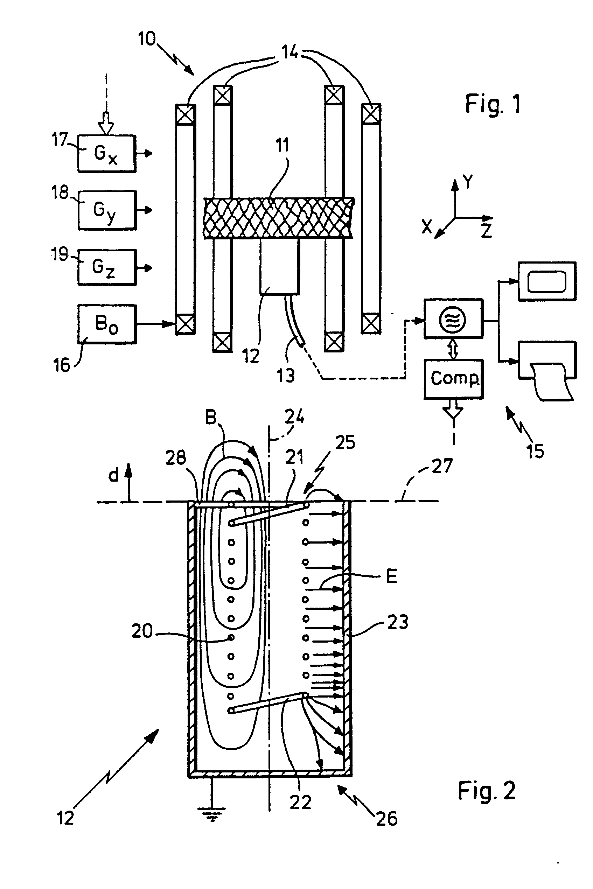

In Fig. 1 bezeichnet 10 insgesamt ein Magnetsystem, das in einem Raum mit den Raumkoordinaten x, y, z angeordnet ist. Die Raumkoordinate z fällt mit der Achse des Magnetsystems 10 zusammen. In der Achse z befindet sich ein schematisch angedeuteter Meßkörper 11, beispielsweise gesamthaft ein Körper eines Patienten oder ein Körperteil, etwa ein Arm oder ein Bein. Es versteht sich jedoch, daß der erfindungsgemäße Meßkopf ebenso wie das erfindungsgemäße Verfahren auch bei nichtorganischen Proben sowie bei Einzelproben von lebendem oder nichtlebendem Gewebe Verwendung finden kann.

Vom Meßkopf 12 führt eine Zuleitung 13 zu einer Sende/Empfangs- und Darstellungseinrichtung 15, wie sie an sich bekannt ist. Die Einrichtung 15 dient zur Steuerung der auf den Meßkörper 11 einwirkenden Magnet- und Hochfrequenzfelder und erlaubt es in an sich bekannter Weise, flächenhafte oder punktförmige Bereiche im Inneren des Meßkörpers 11 auszuwählen und in diesen ausgewählten Bereichen isoliert Kernresonanz anzuregen. Die Einrichtung 15 gestattet ferner in an sich bekannter Weise, aus den gemessenen Kernresonanzsignalen, die entweder durch gepulste Hochfrequenzsignale oder durch kontinuierlich eingestrahlte Hochfrequenzsignale oder aber mittels der Fourier-Transformation erhalten wurden, eine Bilddarstellung des ausgewählten Bereiches vorzunehmen, beispielsweise in dem einzelnen Bildpunkten die Spindichte oder die chemische Verschiebung des jeweiligen Meßpunktes zugeordnet wird.

Die Einrichtung 15 ist jedoch darüber hinaus auch in der Lage, in den angewählten Bereichen hochauflösende Kernresonanzmessungen durchzuführen, die als Spektren dargestellt oder ausgegeben werden.

Das Magnetsystem 10 ist lediglich schematisch angedeutet und besteht aus einer sogenannten doppelten Helmholtz-Anordnung mit zwei Paaren von Helmholtz-Spulen 14. Die Helmholtz-Spulen 14 erzeugen im Inneren ein Konstant-Magnetfeld hoher Homogenität in allen drei Raumkoordinaten x, y, z.

Zur Speisung der Helmholtz-Spulen 14 dient ein Netzgerät 16, und es sind ferner Gradienten-Netzgeräte 17, 18, 19 vorgesehen, die zur Speisung von in Fig. 1 nicht dargestellten Gradientenspulen dienen, mit denen in der genannten Weise einzelne Bereiche im Inneren des Meßkörpers 11 ausgewählt werden können. Die Netzgeräte 16 bis 19 können rechnergesteuert sein und werden von der Einrichtung 15 eingestellt.

Fig. 2 zeigt die Feldverteilung in einem erfindungsgemäß verwendeten Meßkopf 12.

Der Meßkopf 12 besteht im wesentlichen aus einer Wendelleitung 20, wie sie in der Fachliteratur auch als "Helix" bezeichnet wird. Von der Wendelleitung 20 sind der Übersichtlichkeit halber in Fig. 2 nur die oberste Windung 21 und die unterste Windung 22 vollständig dargestellt. Das zweite wesentliche Element des erfindungsgemäßen Meßkopfes 12 ist eine geerdete Abschirmung 23, die sich z.B. in einer Ausführungsform koaxial um die Wendelleitung 20 herum erstreckt. Die Abschirmung 23 mit einer Längsachse 24 weist ein oberes offenes Ende 25 sowie ein unteres geschlossenes Ende 26 auf. Beim Ausführungsbeispiel gemäß Fig. 2 ist die Lage der Wendelleitung 20 bezüglich der Achse 24 derart, daß die oberste, mit der Abschirmung 23 über einen Anschluß 28 verbundene Windung 21 sich etwa in der Ebene des oberen offenen Endes 25 befindet und dort eine Aufsetzebene 27 bildet, d.h. eine Ebene, in der der Meßkopf 12 auf den zu untersuchenden Meßkörper 11 aufgesetzt wird. Das vom oberen offenen Ende 25 abgewandte Ende der Wendelleitung 20 ist hingegen anschlußfrei.

Elektrisch gesehen bedeutet dies, daß die Wendelleitung 20 am oberen offenen Ende 25 mit der Abschirmung 23 über den Anschluß 28 mit Masse verbunden ist, während sie im Bereich ihrer untersten Windung 22 im Abstand vom unteren geschlossenen Ende 26 der Abschirmung 23 elektrisch offen ist.

Damit ergibt sich eine Feldverteilung, wie sie in Fig. 2 in der Hälfte links von der Achse 24 für die magnetischen Feldlinien mit B und in der Hälfte rechts von der Achse 24 für die elektrischen Feldlinien mit E bezeichnet ist. Man erkennt, daß sich die magnetischen Feldlinien B in einer Radialebene der Wendelleitung 20 schließen und insbesondere oberhalb des oberen offenen Endes 25 in den freien Raum hinein erstrecken. Setzt man den Meßkopf 12 in der Aufsetzebene 27 auf den Meßkörper 11 auf, ergibt sich damit eine Verteilung der magnetischen Feldlinien B, derart, daß die Intensität des Magnetfeldes längs einer Koordinate d in Fig. 2 zum Inneren des Meßkörpers 11 hin abnimmt.

Die elektrischen Feldlinien E hingegen verlaufen im wesentlichen im Zwischenraum zwischen Wendelleitung 20 und Abschirmung 23, so daß sie nach außen hin praktisch nicht in Erscheinung treten. Im Bereich oberhalb der Aufsetzebene 27 sind kaum Streufelder der elektrischen Feldlinien E zu beobachten. Die E-Feldliniendichte nimmt außerdem von unten nach oben ab (in Richtung der Aufsetzebene).

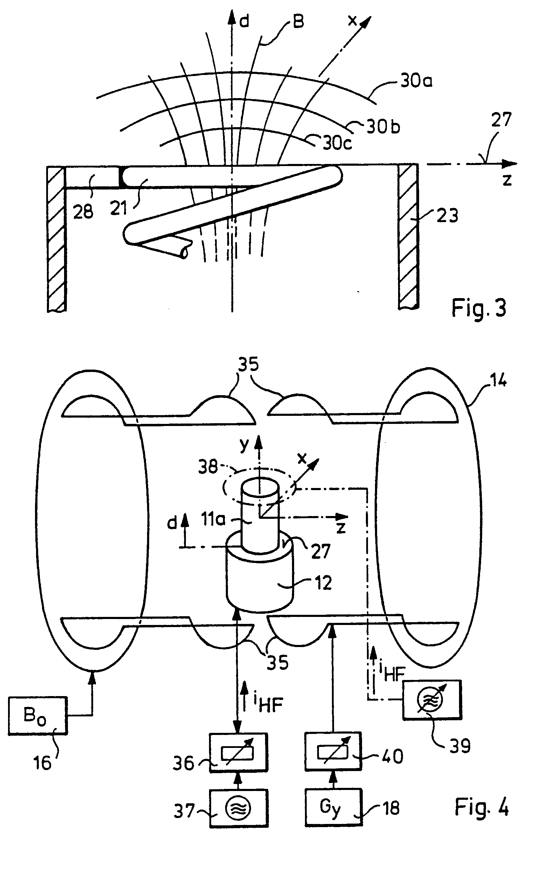

Fig. 3 zeigt im vergrößerten Ausschnitt den Austritt der magnetischen Feldlinien B aus der Aufsetzebene 27. Bekanntlich sind die Ebenen gleicher magnetischer Feldstärke durch gleichen Abstand der Feldlinien B voneinander definiert, so daß diese Ebenen in Fig. 3 als Flächen 30a, 30b, 30c dargestellt werden können, die aus praktischen Gründen leicht gewölbt sind. Bei der Darstellung in Fig. 3 sind die Abstände der Flächen 30a, 30b, 30c voneinander beliebig gewählt, und die Feldstärke nimmt von der Fläche 30a zur Fläche 30b zur Fläche 30c zu.

Würde man nun eine Kernresonanzmessung mit kontinuierlich eingestrahltem Hochfrequenzfeld durchführen, würde aufgrund der durch das gyromagnetische Verhältnis festgelegten Beziehung zwischen Hochfrequenz und Stärke des Konstant-Magnetfeldes im gesamten Raum oberhalb der Aufsetzebene 27 die Resonanzbedingung zu erfüllen sein, unabhängig von der jeweils herrschenden Hochfrequenz-Feldstärke. Wird hingegen zum Anregen der Kernresonanz ein gepulstes Hochfrequenzsignal verwendet, ist die sogenannte 90°- bzw. 270°- bzw. 450°...-Bedingung nur in ganz bestimmten Ebenen erfüllt, weil nur in diesen Ebenen die Hochfrequenz-Feldstärke so groß ist, daß die Spins einer bestimmten Kernart gerade eine Drehung um 90° bzw. 270°... durchführen. Man erhält demzufolge in der Darstellung gemäß Fig. 3 bei geeigneter Einstellung der Parameter eine Situation, in der gerade die Flächen 30a, 30b, 30c den genannten Bedingungen genügen. Da die Hochfrequenz-Feldstärke — wie erwähnt — mit Annäherung an die Aufsetzebene 27 zunimmt, ist beispielsweise in der Fläche 30a die 90°-Bedingung, in der Fläche 30b die 270°-Bedingung und in der Fläche 30c die 450°-Bedingung erfüllt.

Fig. 4 zeigt eine Vorrichtung zur Durchführung einer Ausführungsform eines erfindungsgemäßen Verfahrens.

Mit 35 sind in Fig. 4 Gradienten-Sattelspulen bezeichnet, die einen Gradienten des Konstant-Magnetfeldes in y-Richtung erzeugen. Es wird demzufolge dem in z-Richtung verlaufenden Konstant-Magnetfeld ein Feld überlagert, wonach sich die in z-Richtung gerichtete Feldstärke in ihrem Betrag ändert, wenn man den Innenraum der Spulen 14 in y-Richtung durchläuft.

Dem Meßkopf 12 wird ein Hochfrequenz-Speisestrom $i_{HF}$ über einen Amplitudenregler 36 von einem Hochfrequenz-Sender/Empfänger 37 zugeführt. Die beiden Pfeile in der Zuleitung zwischen Amplitudenregler 36 und Meßkopf 12 symbolisieren, daß auf diese Weise sowohl gesendet wie auch empfangen werden kann, ohne daß es zusätzlicher Hochfrequenzeinrichtungen bedarf.

Die Gradienten-Sattelspulen 35 werden über einen Amplitudenregler 40, der als Stromsteller wirkt, vom Gradienten-Netzgerät 18 gespeist.

Es kann ferner in einer Variante des Ausführungsbeispiels gemäß Fig. 4 eine zusätzliche Sendespule 38 vorgesehen sein, die koaxial zum Meßkopf 12 angeordnet ist und von einem separaten Hochfrequenzsender 39 gespeist wird. In diesem Falle wird ein auf die Aufsetzebene 27 des Meßkopfes 12 aufgesetzter Meßkörper 11a über die separate Sendespule 38 mit einem Hochfrequenz-Magnetfeld beaufschlagt, und der Meßkopf 12 dient lediglich als Antenne im Empfängerbetrieb des Sender/Empfängers 37. Die Sendespule 38 kann ihrerseits eine Helmholtz-Spule sein, sie kann aber auch eine Wendelleitung eines zweiten Meßkopfes sein, dessen Aufbau dem des Meßkopfes 12 entspricht.

Wie man leicht aus Fig. 4 erkennen kann, kann durch Variation des Amplitudenreglers 36 für den Hochfrequenz-Speisestrom $i_{HF}$ die Lage der Flächen 30a bis 30c aus Fig. 3 variiert werden, und es kann außerdem durch Einstellen des Amplitudenreglers 40 für den Speisestrom der Gradienten-Sattelspulen 35 ein Feldprofil eingestellt werden, bei dem die Stärke des Konstant-Magnetfeldes in y-Richtung variiert. Man kann demzufolge in einem vorgegebenen Abstand d von der Aufsetzebene 27 im Inneren des Meßkörpers 11a sowohl den Verlauf der Stärke des Konstant-Magnetfeldes wie auch die Lage der Flächen 30a bis 30c einstellen, in denen die genannten Impuls-Bedingungen erfüllt sind.

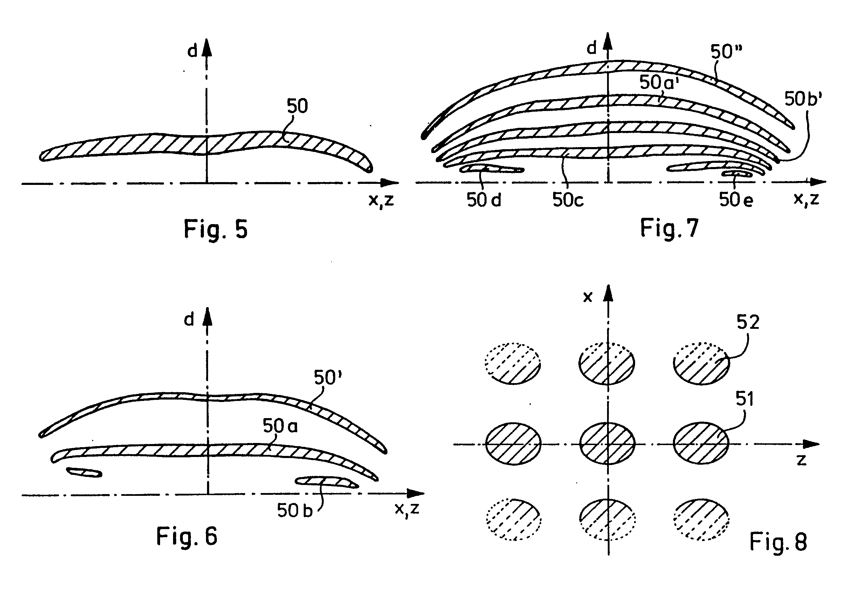

In den Fig. 5 bis 7 sind praktische Meßergebnisse dargestellt, wie sie mit einer Einrichtung gemäß Fig. 4 erhalten wurden.

Zum Durchführen dieser praktischen Versuche wurde ein zylindrisches und mit Wasser gefülltes Glas auf die Aufsetzebene 27 des Meßkopfes 12 gestellt, wie dies in Fig. 4 durch den zylindrischen Meßkörper 11a angedeutet ist.

Gleichzeitig wurde die Darstellungseinrichtung 15 (vgl. Fig. 1) so eingestellt, daß eine Bilddarstellung in einer zur Achse 24 des Meßkopfes 12 parallelen Ebene erzeugt wurde, d.h. in einer yx- bzw. yz-Richtung. Die Darstellungen gemäß Fig. 5 bis 7 sind in y-Richtung nach d parametriert, um den Abstand zur Aufsetzebene 27 zu verdeutlichen.

Fig. 5 zeigt ein Signal 50, wie es mit relativ schwacher Hochfrequenzeinstrahlung erzielt wurde, d.h. der Amplitudenregler 36 stellte beim Experiment gemäß Fig. 5 einen verhältnismäßig geringen Hochfrequenz-Speisestrom $i_{HF}$ ein. In diesem Fall ergab sich lediglich eine einzige Fläche oberhalb der Aufsetzebene 27, in der gerade die 90°-Bedingung erfüllt war. Das Signal 50 stellt somit einen axialen Schnitt durch eine "Scheibe" des Wassers im zylindrischen Glas dar.

Erhöht man nun den Hochfrequenz-Speisestrom $i_{HF}$ durch Verstellen des Amplitudenreglers 36, wandert das Signal 50 zu höheren d-Werten, wie dies aus Fig. 6 ersichtlich wird, wo das Signal 50 nunmehr die Position 50' einnimmt. Weiterhin erkennt man in Fig. 6 eine zweite Resonanzebene, dargestellt durch ein Signal 50a, das einer Scheibe durch den zylindrischen Wasser-Meßkörper entspricht, in dem gerade die 180°-Bedingung erfüllt ist. Außerdem erkennt man in Fig. 6 noch schemenhaft ein weiteres Signal 50b, das einer Querschnittsebene entspricht, in der die 270°-Bedingung erfüllt ist.

Fig. 7 zeigt den Versuch in einer weiteren Phase, in der der Hochfrequenz-Speisestrom $i_{HF}$ zu noch höheren Werten hin verstellt wurde, und man erkennt nunmehr insgesamt sechs Querschnittsebenen 50'', 50a', 50b', 50c, 50d, 50e, in denen jeweils die 90° + n180°-Bedingung erfüllt ist.

Will man nun lediglich eine dieser Flächen 50'' bis 50e untersuchen und in einer zu den Fig. 5 bis 7 senkrechten Ebene bildhaft darstellen, kann man eine dieser Ebenen dadurch anwählen, daß man in der zu Fig. 4 erläuterten Weise einen Gy-Feldgradienten überlagert, so daß nur für eine einzige der Flächen 50'' bis 50e die Resonanzbedingung erfüllt ist.

Fig. 8 zeigt das Ergebnis eines entsprechenden Experimentes, bei dem jedoch statt eines einzigen wassergefüllten Glases auf der Aufsetzebene 27 neun wassergefüllte Reagenzgläser auf die Aufsetzebene 27 des Meßkopfes 12 in einer Richtung parallel zur y-Achse gesetzt wurden. Es wurde nun zunächst eine Einstellung des Hochfrequenz-Speisestromes $i_{HF}$ nach Art von Fig. 6 oder 7 vorgenommen und anschließend eine der dargestellten Flächen dadurch "angewählt", daß ein Gy-Feldgradient überlagert wurde, der nur in einer dieser Flächen die Resonanzbedingung erfüllte. Alle übrigen Flächen wurden dadurch "ausgeblendet", so daß die Signal- und Bildverarbeitung durch die Einrichtung 15 besonders einfach und schnell erfolgen konnte.

In Fig. 8 erkennt man die neun geschnittenen Reagenzgläser als Signale 51 bzw. 52, wobei die Signale 52 in den Randbereichen nach außen hin verschwimmen. Dies ist deswegen nicht überraschend, weil aus der Darstellung gemäß Fig. 3 bereits zu erwarten war, daß die Signalflächen 50 gemäß Fig. 5 bis 7 in d-Richtung gewölbt verlaufen. Da andererseits beim Experiment gemäß Fig. 8 ein linearer y-Feldgradient Gy überlagert wurde, bedeutet dies, daß an den Rändern der Signalflächen 50 die Resonanzbedingung immer weniger erfüllt war, so daß dort die Signale verlaufen. Für eine vollständig lineare und ganzflächig deckende Bilddarstellung muß man daher entweder den linearen Zentrumsbereich der Signalflächen 50 ausnutzen oder aber den Meßkopf 12 entsprechend vergrößern.

**Patentansprüche**

1. Verfahren zur Aufnahme von Kernresonanzsignalen in definierten Bereichen eines Meßkörpers (11, 11a), der sich in einem homogenen Konstant-Magnetfeld ($B_0$) befindet, wobei ein Meßkopf (12) verwendet wird, der eine auf den Meßkörper (11, 11a) aufsetzbare Hochfrequenz-Sende- und/oder -Empfangseinrichtung umfaßt, die als Wendelleitung (20) mit koaxialer Abschirmung (23) ausgebildet und an mindestens einem Ende (25) offen und am anderen Ende anschlußfrei ist, wobei die oberste, mit der Abschirmung (23) über einen Anschluß (28) verbundene Windung (21) der Wendelleitung (20) sich etwa in der Ebene des oberen offenen Endes (25) befindet und dort die Aufsetzebene (27) bildet, wobei ferner durch Variation des Hochfrequenz-Speisestromes ($i_{HF}$) einer zum Meßkopf (12) koaxialen Sendespule (20; 38) mindestens eine Fläche (30a bis 30c) konstanter magnetischer Hochfrequenz-Feldstärke (B) in einem definierten Abstand (d) oberhalb der Aufsetzebene (27) erzeugt wird, in der bei impulsförmig getastetem Speisestrom ($i_{HF}$) für eine vorgegebene Kernart die Resonanzbedingung unter Bezug auf das homogene Konstant-Magnetfeld ($B_0$) erfüllt ist, und wobei schließlich eine Bilddarstellung der einen ausgewählten Fläche (30a bis 30c) in ihrer Ebene vorgenommen wird.

2. Verfahren nach Anspruch 1, dadurch gekennzeichnet, daß in mindestens zwei der Flächen (30a bis 30c) die 90°- bzw. 270°- bzw. 450°...-Bedingung der gepulsten magnetischen Kernresonanz erfüllt ist.

3. Verfahren nach Anspruch 2, dadurch gekennzeichnet, daß durch Überlagerung und definierte Einstellung eines in der Spulenachse (y) wirkenden Gradienten (Gy) des Konstant-Magnetfeldes ($B_0$) eine der mehreren Flächen (30a bis 30c) ausgewählt wird.

4. Verfahren nach einem der Ansprüche 1 bis 3, dadurch gekennzeichnet, daß die Bilddarstellung die Spindichte jedes Bildpunktes zeigt.

5. Verfahren nach einem der Ansprüche 1 bis 3, dadurch gekennzeichnet, daß die Bilddarstellung die chemische Verschiebung jedes Bildpunktes zeigt.

6. Verfahren nach einem der Ansprüche 1 bis 5, dadurch gekennzeichnet, daß nach Vornahme der Bilddarstellung in dem durch die ausgewählte Fläche (30a bis 30b) definierten Bereich des Meßkörpers (11, 11a) oder in einem Teil dieses Bereiches eine hochauflösende Kernresonanzmessung erfolgt.

7. Verfahren nach einem der Ansprüche 1 bis 6, dadurch gekennzeichnet, daß als Sendespule die Wendelleitung (20) verwendet wird.

8. Verfahren nach einem der Ansprüche 1 bis 6, dadurch gekennzeichnet, daß als Sendespule eine vom Meßkopf (12) getrennte Sendespule (38) verwendet wird.

9. Verfahren nach Anspruch 8, dadurch gekennzeichnet, daß als getrennte Sendespule (38) eine zum Meßkopf (12) koaxiale Helmholtz-Spule verwendet wird.

10. Verfahren nach Anspruch 8, dadurch gekennzeichnet, daß als getrennte Sendespule eine Wendelleitung eines weiteren Meßkopfes verwendet wird.

11. Vorrichtung zur Durchführung des Verfahrens nach einem der Ansprüche 1 bis 10, wobei zuzüglich zur Sende/Empfangseinrichtung eine Darstellungseinrichtung (15) vorgesehen ist, die die in dem durch mindestens eine Fläche (30a bis 30c) definierten räumlichen Bereich des Meßkörpers (11, 11a) angeregte Kernresonanz bildlich darstellt.

12. Vorrichtung nach Anspruch 11, dadurch gekennzeichnet, daß die Einrichtung (15) den Meßkopf (12) als Sender und Empfänger aufweist.

13. Vorrichtung nach Anspruch 11, dadurch gekennzeichnet, daß die Einrichtung (15) den Meßkopf (12) als Empfänger und eine getrennte Sendespule (38) als Sender aufweist.

14. Vorrichtung nach Anspruch 13, dadurch gekennzeichnet, daß die getrennte Sendespule (38) eine Helmholtz-Spule ist.

15. Vorrichtung nach Anspruch 13, dadurch gekennzeichnet, daß die getrennte Sendespule eine Wendelleitung eines weiteren Meßkopfes ist.

## Revendications

1. Procédé pour capter des signaux de résonance nucléaire dans des parties déterminées d'un corps de mesure (11, 11a) qui se situe dans un champ magnétique constant et homogène ($B_0$), du type dans lequel on utilise une tête de mesure (12) qui comporte un dispositif émetteur et/ou récepteur haute fréquence qui est susceptible d'être appliqué sur le corps de mesure (11, 11a) et qui est réalisé sous la forme d'un conducteur hélicoïdal (20) à blindage coaxial (23) et qui est ouvert à au moins une extrémité (25) et sans branchement à l'autre extrémité, du type dans lequel la spire supérieure (21) du conducteur hélicoïdal (20) qui est reliée avec l'écran (23) par l'intermédiaire d'un branchement et se situe sensiblement dans le plan de l'extrémité supérieure ouverte (25) et y forme un plan d'application (27), dans lequel, en outre, en faisant varier le courant d'alimentation haute fréquence ($i_{HF}$) d'une bobine émettrice (20; 38) coaxiale à la tête de mesure (12), on produit au moins une surface (30a à 30c) à intensité de champ magnétique constant de haute fréquence (B), à une distance déterminée (d) au-dessus du champ d'application (27), dans laquelle on crée, dans le cas d'un courant d'alimentation impulsionnel ($i_{HF}$) et pour un genre nucléaire prédéterminé, la condition de résonance corrélativement au champ magnétique constant et homogène ($B_0$), et dans lequel, finalement on procède à la représentation de l'image de l'une des surfaces sélectionnées (30a à 30c) dans son plan.

2. Procédé selon la revendication 1, caractérisé par le fait que dans au moins deux surfaces (30a à 30c) sont satisfaites la condition à 90°, 270°, ou 450°, la condition de la résonance nucléaire magnétique pulsée.

3. Procédé selon la revendication 2, caractérisé par le fait que par la superposition et le réglage déterminé d'un gradient ($G_y$), agissant dans l'axe (y) de la bobine, du champ magnétique constant ($B_0$), on sélectionne l'une de la pluralité des surfaces (30a à 30c).

4. Procédé selon l'une des revendications 1 à 3, caractérisé par le fait que la représentation par l'image, montre la densité de spin de chaque point d'image.

5. Procédé selon l'une des revendications 1 à 3, caractérisé par le fait que la représentation par l'image montre le déplacement chimique de chaque point d'image.

6. Procédé selon l'une des revendications 1 à 5, caractérisé par le fait qu'après examen de la représentation par image dans la partie du corps de mesure (11, 11a), qui est définie par la surface sélectionnée (30a à 30b), ou dans une portion de cette partie, on procède à une mesure de la résonance nucléaire à haute définition.

7. Procédé selon l'une des revendications 1 à 6, caractérisé par le fait que l'on utilise, en tant que bobine émettrice, le conducteur hélicoïdal (20).

8. Procédé selon l'une des revendications 1 à 6, caractérisé par le fait que l'on utilise, en tant que bobine émettrice, une bobine émettrice (38) qui est distincte de la tête de mesure (12).

9. Procédé selon la revendication 8, caractérisé par le fait que l'on utilise, comme bobine émettrice distincte ou séparée (38), une bobine de Helmholtz qui est coaxiale à la tête de mesure (12).

10. Procédé selon la revendication 8, caractérisé par le fait que l'on utilise, en tant que bobine émettrice distincte ou séparée, un conducteur hélicoïdal d'une seconde tête de mesure.

11. Dispositif pour la mise en oeuvre du procédé selon l'une des revendications 1 à 10, dans lequel il est prévu, en plus du dispositif émetteur/récepteur, un dispositif de représentation ou de visualisation (15) qui représente, par image, la résonance nucléaire excitée dans la partie spatiale du corps de mesure (11, 11a), définie par au moins une surface (30a à 30c).

12. Dispositif selon la revendication 11, caractérisé par le fait que le dispositif (15) comporte la tête de mesure (12) en tant qu'émetteur et récepteur.

13. Dispositif selon la revendication 11, caractérisé par le fait que le dispositif (15) comporte la tête de mesure (12) en tant que récepteur et, en tant qu'émetteur, une bobine émettrice séparée ou distincte (38).

14. Dispositif selon la revendication 13, caractérisé par le fait que la bobine émettrice distincte ou séparée (38) est une bobine de Helmholtz.

15. Dispositif selon la revendication 13, caractérisé par le fait que la bobine émettrice distincte ou séparée est constituée par un émetteur hélicoïdal d'une tête de mesure supplémentaire.

**Claims**

1. A method of picking up nuclear resonance signals in specific areas of a measuring body (11, 11a) disposed in an homogeneous constant magnetic field (B₀), a measuring head (12) being used which comprises, adapted to be mounted on the measuring body (11, 11a), a high frequency transmitting and/or receiving means constructed as a coiled conductor (20) with a coaxial screening (23) and which is open at least at one end (25) and free from connections at the other end, the topmost winding (21) of the coiled conductor (20) which is connected to the screening (23) via a connection (28) being disposed substantially in the plane of the upper open end (25), forming there the plane (27) of application, whereby furthermore, by varying the high frequency feed current ($i_{HF}$) of a transmission coil (20, 38) coaxial with the measuring head (12), at least one area (30a to 30c) of constant magnetic high frequency field strength (B) is generated at a specific distance (d) above the plane of application (27) in which, with a pulsatingly scanned feed current ($i_{HF}$) for a given type of nucleus the resonance condition is satisfied with reference to the homogeneous constant magnetic field (B₀), and in which finally there is a graphic representation of the one area (30a to 30c) in its plane.

2. A method according to Claim 1, characterised in that in at least two of the areas (30a to 30c) the 90° or 270° or 450° condition of the pulsed magnetic nuclear resonance is fulfilled.

3. A method according to Claim 2, characterised in that by superimposition and clearly defined adjustment of a gradient ($G_y$) of the constant

magnetic field (B₀) which acts in the coil axis (y) one of the several areas (30a to 30c) is selected.

4. A method according to one of Claims 1 to 3, characterised in that the graphic representation shows the spin density of each picture element.

5. A method according to one of Claims 1 to 3, characterised in that the graphic representation shows the chemical shift of each picture element.

6. A method according to one of Claims 1 to 5, characterised in that once the graphic representation has been effected in the area of the measuring body (11, 11a) which is defined by the selected area (30a to 30b) or in a part of this area, a high-resolution nuclear resonance measurement is performed.

7. A method according to one of Claims 1 tc 6, characterised in that the coiled conductor (20) is used as the transmission coil.

8. A method according to one of Claims 1 to 6, characterised in that a transmission coil (38) separate from the measuring head (12) is used as the transmission coil.

9. A method according to Claim 8, characterised in that a Helmholtz coil coaxial with the measuring head (12) is used as the separate transmission coil (38).

10. A method according to Claim 8, characterised in that a coiled conductor of a further measuring head is used as the separate transmission coil.

11. An apparatus for carrying out the method according to one of Claims 1 to 10, in which in addition to the transmitting/receiving arrangement, a display means (15) is provided which graphically displays the nuclear resonance stimulated in the spatial area of the measuring body (11, 11a) which is defined by at least one area (30a to 30c).

12. An apparatus according to Claim 11, characterised in that the arrangement (15) comprises the measuring head (12) as a transmitter and a receiver.

13. An apparatus according to Claim 11, characterised in that the arrangement (15) comprises a measuring head (12) as a receiver and a separate transmission coil (38) as the transmitter.

14. An apparatus according to Claim 13, characterised in that the separate transmission coil (38) is a Helmholtz coil.

15. An apparatus according to Claim 13, characterised in that the separate transmission coil is a coiled conductor of a further measuring head.

Fig. 1

17 $G_x$

18 $G_y$

19 $G_z$

16 $B_o$

10

14

11

12

13

15

Comp.

Y

X

Z

Fig. 2

d

B

28

24

21

25

27

20

E

23

12

22

26

Fig. 3

Fig. 4

d

50

x,z

Fig. 5

d

50"

50a'

50b'

50d    50c    50e    x,z

Fig. 7

d

50'

50a

50b

x,z

Fig. 6

x

52

51

z

Fig. 8

EP 0 202 455 B1

3